# EUROPEAN PATENT APPLICATION

(11) **EP 0 691 736 A1**
(43) Date of publication of application: **10.01.1996**
(21) Application number: 95304696.8
(22) Date of filing: 05.07.1995
(51) Int. Cl.: H03G 1/02, H03G 3/00, H03G 5/02, H04H 1/00

(54) **Control of audio effects in radio receivers**

(30) Priority: 05.07.1994 US 270878
(71) Applicant: Ford Motor Company, Dearborn, MI 48126 (US)
(72) Inventor: Arrowsmith, Douglas Scott, Milford, Michigan 48381 (US); Miller, Kenneth Christopher, Canton, Michigan 48187 (US)
(74) Representative: Messulam, Alec Moses

(57) **Abstract**

A radio receiver detects program information from an auxiliary data signal contained in a radio broadcast according to a predetermined format such as the radio broadcast data system (RBDS). Audio effects such as tone settings and sound-field simulations are adjusted in accordance with RBDS codes. Either default audio effects or user-set audio effects can be invoked in response to the RBDS codes.

## Description

The present invention relates in general to radio receivers capable of receiving broadcasts having auxiliary data signals, and more specifically to controlling audio effects according to codes contained in the auxiliary data signal.

This application is related to co-pending application U.S. Serial No. 08/270879 entitled "Radio Station Memory Presets with Stored Audio Effects", which is incorporated herein by reference.

Radio broadcasters have adopted standards for and have recently begun broadcasting auxiliary data signals with their main program information. These auxiliary data signals provide information concerning the main program signal such as an identification of the broadcaster, type of program format of the broadcast, and an indication of whether traffic information is available in the broadcast. Examples of these systems are the Radio Data System (RDS) adopted by the European Broadcast Union and the Radio Broadcast Data System (RBDS) adopted in the United States by the National Association of Broadcasters.

The information contained in the auxiliary data signal facilitates sophisticated control of a radio receiver. For example, an examination of codes in the auxiliary data signal facilitate search tuning to certain desired program types and/or traffic announcements.

Another feature of radio receivers is the ability to adjust a variety of treatments or audio effects for the received audio signal. Tonal qualities can be adjusted to the listener's preference, including treble level control and bass level control. Equalisers are employed to adjust the levels of more finely divided audio frequency ranges. The sound image can also be adjusted using left-right balance and front-rear fade controls.

With the introduction of digital signal processing (DSP), additional treatments of the received audio signal are becoming available. For example, sound field simulation (also called concert hall emulation) adds selected reverberation to the reproduced audio to simulate various listening environments such as a concert hall, jazz club, or a stadium.

These various audio effects allow individual listeners to optimise an audio system to their individual preferences depending on the type of broadcast programming being received. For example, when listening to a "talk" radio station, it may be desirable to cut low frequencies to reduce "boominess" and to cut high frequencies to reduce noise, thereby improving speech intelligibility. Some operators/listeners may prefer to enhance bass levels when listening to rock, while some may prefer to enhance treble level when listening to classical or jazz music. Sound field simulation will also be selected according to the type of programming being received. For example, a jazz hall emulation may be desirable when listening to a jazz broadcast station.

When an operator retunes a receiver in order to listen to a different broadcast station, the audio effects can be readjusted to suit the programming of the new station. However, accessing these unique audio effects each time a radio station is retuned can become inconvenient.

The present invention utilises specific information from an auxiliary data signal to control audio effects, including bass, treble, balance, and fade settings and also sound-field emulation settings, if available.

More specifically, the present invention includes an audio system having a radio tuner selectably tunable to a plurality of broadcast stations. The broadcast stations transmit a main program signal and an auxiliary data signal containing codes providing program information with respect to the main program signal. An audio processor treats an audio signal derived from the tuner with selected audio effects. A memory stores a respective audio effect corresponding to at least one of the codes. A control is responsive to the codes and causes the audio processor to treat the audio signal with the respective audio effect when the at least one code is received by the radio tuner.

The invention will now be described further, by way of example, with reference to the accompanying drawings, in which:
Figure 1 is a block diagram showing a radio receiver according to the present invention;
Figure 2 illustrates the frequency spectrum of an FM stereo broadcast including an RBDS auxiliary data signal;
Figure 3 illustrates some of the contents of an auxiliary data signal;
Figure 4 is a flow-chart showing a preferred method according to the present invention; and
Figure 5 shows memory contents used in the present invention.

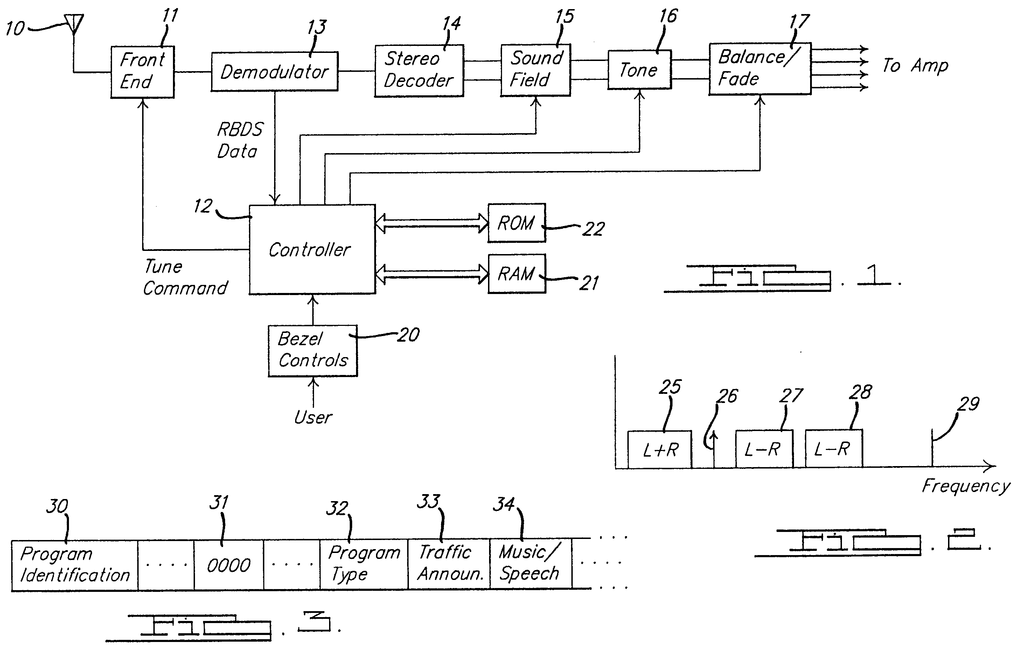

Referring to Figure 1, an antenna 10 receives radio frequency broadcast signals from a plurality of broadcast stations, some of which transmit auxiliary data signals. Examples are stations transmitting an RBDS signal in the United States or an RDS signal in Europe. The broadcast signals picked up by antenna 10 are provided to a front end 11 which selects one of the broadcast signals in response to a tune command from a controller 12. Front end 11 generates an intermediate frequency (IF) signal which is demodulated by a demodulator 13.

Demodulator 13 provides a main program signal (e.g., speech or music) to a stereo FM decoder 14. Demodulator 13 also separates the auxiliary data signal which is provided to controller 12. A stereo signal from stereo decoder 14 is further processed by a sound field generator 15, a tone generator 16, and a balance/fade generator 17. Block 15-17 collectively provide an audio processor for treating an audio signal with selected audio effects. Controller 12 provides respective control signals to blocks 15-17 causing the audio processor to treat the audio signal with the selected audio effects.

Desired audio effects may be adjusted by a user via bezel controls 20 connected to controller 12. The audio effects selected by the user are stored in a random access memory (RAM) 21 connected to controller 12. In addition, selected audio effects may be obtained from a read only memory (ROM) 22 connected to controller 12. Either the user-set audio effects contained in RAM 21 or the default audio effects contained in ROM 22 may be invoked by controller 12 in response to codes providing program information in the RBDS data from demodulator 13, as will be described below.

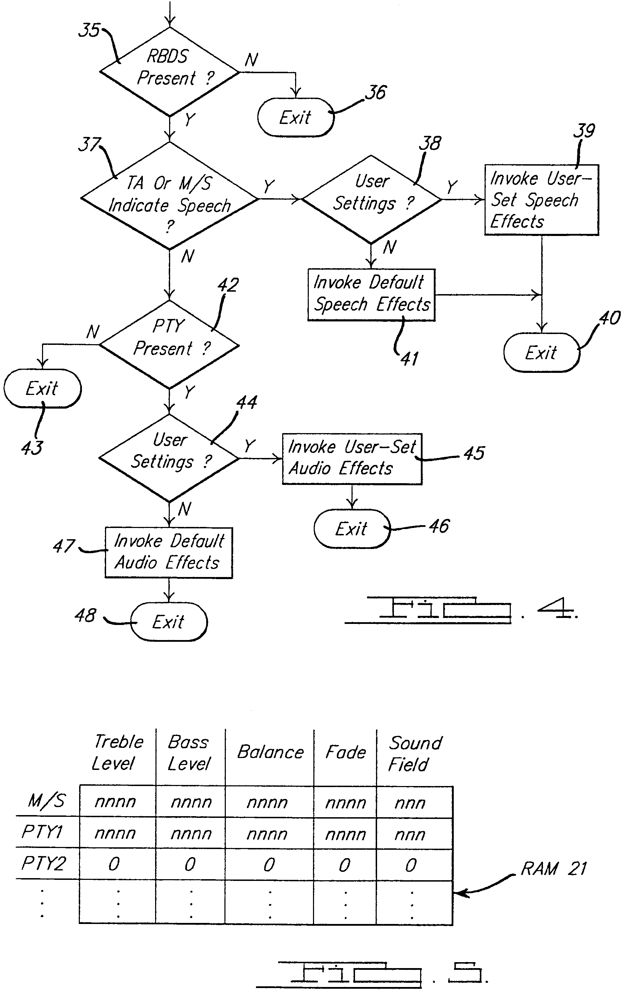

Figure 2 shows the frequency spectrum of a typical FM stereo broadcast signal including RBDS sub-carrier information. A stereo sum signal 25 is transmitted together with a stereo pilot 26, stereo difference channels 27 and 28, and a RBDS signal 29. The RBDS signal is typically amplitude modulated and provides a representation of a serial digital data stream containing information codes according to a predefined standard.

In the RDS and RBDS standards, the serial data is organised into groups of different types. Each group type has a respective format and includes particular codes representing program information corresponding to the main program signal. Figure 3 illustrates portions of a group providing basic tuning and switching information (which is group type 0 in RBDS). The group includes a program identification (PI) code 30 to identify the broadcaster. A group type code 31 is set to all zero's indicating that this is a type zero group. A program type (PTY) code 32 identifies which of several predetermined program type formats describes the main program signal being broadcast. As determined in the RBDS standard, a PTY code value identifies a particular program type as follows: 0 means there is no program type code, 1 is news, 2 is information, 3 is sports, 4 is talk, 5 is rock, 6 is classic rock, 7 is adult hits, 8 is soft rock, 9 is top 40 hits, 10 is country, 11 is oldies, 12 is soft, 13 is nostalgia, 14 is jazz, 15 is classical, and so forth.

A traffic announcement (TA) identification 33 is comprised of a single bit in the group and indicates whether a traffic announcement is currently being broadcast in the main program signal. A music/speech (M/S) switch 34 is also a single bit and identifies whether the main program signal includes music or speech. In the event that a particular broadcaster is not utilising this switch, the bit is set to a value indicating music.

The method by which the present invention controls audio effects in response to the program information contained in the auxiliary data signal is shown in Figure 4. Steps performed by controller 12 of Figure 1 include an RBDS subroutine which begins with a check in step 35 to determine whether an RBDS auxiliary data signal is present in the broadcast. If not, the subroutine is exited in step 36. Otherwise, a check is made in step 37 to determine whether a traffic announcement code or a music/speech code is present that would indicate speech in the main program signal. If speech is present, then a check is made in step 38 to determine whether any user settings have been provided for the audio effects. For example, user settings for a particular RBDS code such as traffic announcement or music/speech can be specifically set by the user using the bezel controls and explicitly saved by the user in association with the particular RBDS code. Alternatively, user settings may be automatically saved whenever the user makes an audio effect adjustment using the bezel controls at a time when the currently received broadcast includes an auxiliary data signal having a code value indicating that a traffic announcement or speech is present. If user-set audio effects corresponding to bass, treble, balance, fade, and/or sound field emulation are available, then these user-set speech effects are invoked in step 39 and the subroutine is exited in step 40. If user settings are not available, then default speech effects are invoked in step 41 and the subroutine is exited in step 40. The default effects are contained in ROM and may be determined by the manufacturer of the radio receiver according to parameters which provide the best speech intelligibility. In an automotive audio system, these default effects may also take into account the acoustic properties within the particular automobile.

If speech is not indicated in step 37, then a check is made in step 42 for a program type code. If there is no PTY present then the subroutine is exited in step 43. Otherwise, a PTY code is present and a check is made in step 44 to determine whether user settings are available corresponding to the PTY code. Any user settings are invoked in step 45 and the subroutine is then exited in step 46. Otherwise, the manufacturers default audio effects are invoked in step 47 and the subroutine is exited in step 48.

The types of audio effects that may be desirable according to various codes present in the RBDS signal include high frequency cut and low frequency cut for speech, bass boost for rock, or treble boost for classical, according to the tastes of a listener or according to sound quality adjustments determined the manufacturer. In addition, sound image may be varied by adjusting balance and fade levels. For example, a front image may be desirable for speech while a rear image may be desirable for music.

User-set audio effects may be stored in a table contained within RAM 21 as shown in Figure 5. The table includes a plurality of rows, each row corresponding to an RBDS code. For example, the first row corresponds to a music/speech (M/S) identification. Corresponding values for the treble level, bass level, balance, fade, and sound field can be set and stored by the user or can be dynamically stored whenever these values are adjusted while that RBDS code is being received. Additional rows in the table correspond to program type codes such as PTY1 and PTY2. PTY1 has received some arbitrary values designated by "nnnn" for example. No user set value has been set for code PTY2 as indicated by zero values in the table. A similar table is contained in ROM 22 for providing the default audio effects. A memory organisation other than use of contiguous locations in a table can be used provided that the relationship between each auxiliary data code and its respective audio effects is maintained.

## Claims

1. An audio system comprising:
a radio tuner (10,11,12) selectably tunable to a plurality of broadcast stations including broadcast stations transmitting a main program signal and an auxiliary data signal, said auxiliary data signal containing codes providing program information with respect to said main program signal;
an audio processor (15-17) coupled to said radio tuner treating an audio signal derived from said tuner with selected audio effects;
a memory (21) storing a respective audio effect corresponding to at least one of said codes; and
a control (12,20) responsive to said codes and causing said audio processor to treat said audio signal with said respective audio effect when said at least one code is received by said radio tuner.

2. An audio system as claimed in claim 1, wherein said codes include a program type code or a music/speech code.

3. An audio system as claimed in claim 2, wherein said memory includes a table relating a plurality of said program types each to a respective audio effect.

4. An audio system as claimed in claim 3, wherein said table includes predetermined default audio effects contained in permanent storage.

5. An audio system as claimed in claim 3, wherein said table includes audio effects that are user adjustable.

6. An audio system as claimed in claim 1, wherein said selected audio effects include treble level and bass level.

7. An audio system as claimed in claim 1, wherein said selected audio effects include a sound field simulation.

8. A method of operating an audio system including a broadcast radio receiver selectably tunable to a plurality of broadcast stations including broadcast stations transmitting a main program signal and an auxiliary data signal, said auxiliary data signal containing codes providing program information with respect to said main program signal:
tuning said receiver to a desired broadcast station;
detecting a code transmitted by said desired broadcast station; and
treating an audio signal from said desired broadcast station with an audio effect selected in response to said code.

9. A method as claimed in claim 8, wherein said audio effect is selected according to a predetermined default audio effect associated with said detected code.

10. A method as claimed in claim 8, wherein said audio effect is selected according to a user-specified audio effect associated with said detected code.
